# EUROPÄISCHE PATENTSCHRIFT

(11) **EP 0 408 780 B1**
(45) Veröffentlichungstag und Bekanntmachung des Hinweises auf die Patenterteilung: **23.03.1994**
(21) Anmeldenummer: 89113162.5
(22) Anmeldetag: 18.07.1989
(51) Int. Cl.: H03D 13/00, H03K 5/13, G01R 25/00

(54) **Digitaler Phasendetektor**
Digital phase detector
Détecteur de phase numérique

(43) Veröffentlichungstag der Anmeldung: 23.01.1991
(73) Patentinhaber: SIEMENS AKTIENGESELLSCHAFT, 80333 München (DE)
(72) Erfinder: Mühlbauer, Klaus-Dieter, Dipl.-Ing., D-8038 Gröbenzell (DE)

(56) Entgegenhaltungen:
- EP-A- 0 054 322
- US-A- 4 535 459
- US-A- 4 791 628

## Beschreibung

Die Erfindung bezieht sich auf einen digitalen Phasendetektor mit zwei in Kette geschalteten bistabilen Kippgliedern, wobei dem ersten Kippglied an seinem Signaleingang eine Digitalsignalfolge und an seinem Takteingang eine Referenztaktimpulsfolge zugeführt ist und der Ausgang des ersten Kippgliedes mit dem Signaleingang des zweiten Kippgliedes verbunden ist, das an seinem Takteingang gegensinnig zum ersten Kippglied mit dem Referenztakt beaufschlagt ist, wobei ein mit seinem Ausgang einen ersten Phasenregelsignalausgang bildendes EXCLUSIV-ODER-Glied eingangsseitig mit dem Signalausgang des ersten Kippgliedes und mit dem Signalausgang des zweiten Kippgliedes verbunden ist und wobei eine mit ihrem Ausgang einen zweiten Phasenregelsignalausgang bildende Verknüpfungsschaltung eingangsseitig mit dem Signalausgang des ersten Kippgliedes und mit einem Ausgang der Signalverzögerungseinrichtung verbunden ist, die ihrerseits mit der Datensignalfolge beaufschlagt ist.

Eine derartige Anordnung ist z.B. durch das US-Patent 4 535 459 und aus IEEE Journal of Lightwave Technology, VOL.LT-3, No.6, December 1985, bekannt. Bei dieser bekannten Anordnung wird die zur Kompensation der Laufzeit in dem erwähnten ersten Kippglied vorgenommene Signalverzögerung des Datensignals durch RC-Laufzeitglieder bewirkt. Bei niedrigen Digitalsignalraten mag dies ausreichend sein, bei höheren Bitraten wie etwa bei 565 kbit/s ist eine Laufzeitkompensation durch RC-Laufzeitglieder allenfalls durch sehr exaktes Abstimmen auf die durch Herstellungstoleranzen bedingt unterschiedlich ausfallende Signaldurchschaltezeit des ersten Kippgliedes durchzuführen, wobei indessen trotz exakter Abstimmung auftretende Temperaturgänge, die ein anderes elektrodynamisches Verhalten der Bauelemente verursachen, unberücksichtigt bleiben.
Der Erfindung liegt die Aufgabe zugrunde, einen Weg zu zeigen, wie bei einem digitalen Phasendetektor der eingangs genannten Art ein exakter Signallaufzeitausgleich durchgeführt werden kann.

Die Aufgabe wird erfindungsgemäß dadurch gelöst, daß die Signalverzögerungseinrichtung aus zwei dem ersten Kippglied entsprechenden, gegensinnig zueinander mit der Datensignalfolge beaufschlagten bistabilen Kippgliedern gebildet ist, welche jeweils bei Auftreten einer ansteigenden Digitalsignalflanke am Ausgang des einen Kippgliedes der Signalverzögerungseinrichtung und beim Auftreten einer abfallenden Digitalsignalflanke am Ausgang des anderen Kippgliedes der Signalverzögerungseinrichtung ein Digitalsignal erzeugen, das jeweils durch ein Rücksetzsignal in seiner Signaldauer begrenzt wird und über die nachfolgende Verknüpfungsschaltung ein zugehöriges Phasenregelsignal erzeugt; dabei ist es in weiterer Ausgestaltung der Erfindung möglich, daß der Signaleingang jedes der gegensinnig zueinander mit der Datensignalfolge beaufschlagten Kippglieder der Signalverzögerungseinrichtung mit einem Festsignal beaufschlagt ist und ein negierender Takteingang des einen Kippgliedes sowie ein nichtnegierender Takteingang des anderen Kippgliedes mit der Digitalsignalfolge beaufschlagt ist, daß der Ausgang desjenigen UND-Gliedes des mit zwei UND-Gliedern und einem diese zusammenfassende ODER-Glied gebildeten EXCLUSIV-ODER-Gliedes, das mit dem negierten Ausgangssignal des ersten Kippgliedes und mit dem nichtnegierten Ausgangssignal des zweiten Kippgliedes gesteuert wird, mit einem Rücksetzeingang des den negierenden Takteingang aufweisenden Kippgliedes der Signalverzögerungseinrichtung verbunden ist, und daß der Ausgang desjenigen UND-Gliedes des EXCLUSIV-ODER-Gliedes, das mit dem nichtnegierten Ausgangssignal des ersten Kippgliedes und mit dem negierten Ausgangssignal des zweiten Kippgliedes gesteuert wird, mit dem Rücksetzeingang des den nichtnegierenden Takteingang aufweisenden Kippgliedes verbunden ist.

Die Erfindung bringt den Vorteil mit sich, daß die Signallaufzeit des ersten in Kette geschalteten Kippgliedes in dem einen und dem anderen Kippglied der Signalverzögerungseinrichtung exakt nachgebildet wird, so daß das am Ausgang der Verknüpfungsschaltung auftretende zweite Phasenregelausgangssignal "up" nicht durch Signallaufzeiten des ersten Kippgliedes gegenüber dem ersten Phasenregelausgangssignal "down" des EXCLUSIV-ODER-Gliedes zeitlich verfälscht ist.
Durch die Begrenzung der einzelnen Digitalsignale in ihrer Signaldauer werden mögliche Überschneidungen im Grenzbereich zwischen der ansteigenden Flanke des einen und der abfallenden Flanke des anderen Digitalsignals in der nachfolgenden Verknüpfungsschaltung vermieden.

Eine vorteilhafte Weiterbildung der Erfindung ist dadurch gekennzeichnet, daß die der Signalverzögerungseinrichtung nachfolgende Verknüpfungsschaltung aus zwei UND-Gliedern und einem zusammenfassenden ODER-Glied besteht, wobei der jeweils eine Eingang der beiden UND-Glieder mit dem Signalausgang des einen bzw. anderen Kippgliedes der Signalverzögerungseinrichtung verbunden ist und wobei der andere Eingang desjenigen UND-Gliedes, das mit dem mit der invertierten Datensignalfolge beaufschlagten einen Kippglied der Signalverzögerungseinrichtung verbunden ist, mit dem nichtinvertierten Ausgangssignal des ersten Kippgliedes beaufschlagt wird, während der andere Eingang des anderen UND-Gliedes der Verknüpfungsschaltung mit dem invertierten Ausgangssignal des ersten Kippgliedes beaufschlagt wird. Durch weitgehende strukturelle Gleichheit der beiden die Phasenregelsignale bildenden Verknüpfungsschaltungen und Funktionsgleichheit ihrer Verknüpfungsglieder wird so der zunächst im Phasendetektor erzielte exakte Laufzeitausgleich bis zu den Ausgängen des Phasendetektors hin beibehalten.
Zweckmäßigerweise liegen in weiterer Ausgestaltung der Erfindung die Kippglieder der Signalverzögerungsschaltung mit den zwei in Kette geschalteten bistabilen Kippgliedern in der gleichen Schichtebene eines integrierten Schaltkreises, womit auch Leitungslaufzeiten innerhalb des jeweiligen Schaltkreises, Temperaturgänge, dotierungs- sowie schichtspezifische Einflußgrößen trotz sehr hoher Bitraten (z.B. 565 kbit/s) unberücksichtigt bleiben können.

Anhand von Zeichnungen sei die Erfindung im folgenden noch näher erläutert. Dabei zeigt
- FIG 1: ein Prinzipschaltbild eines Ausführungsbeispiels eines digitalen Phasendetektors gemäß der Erfindung, und
- FIG 2: zeigt darin auftretende Signalverläufe.

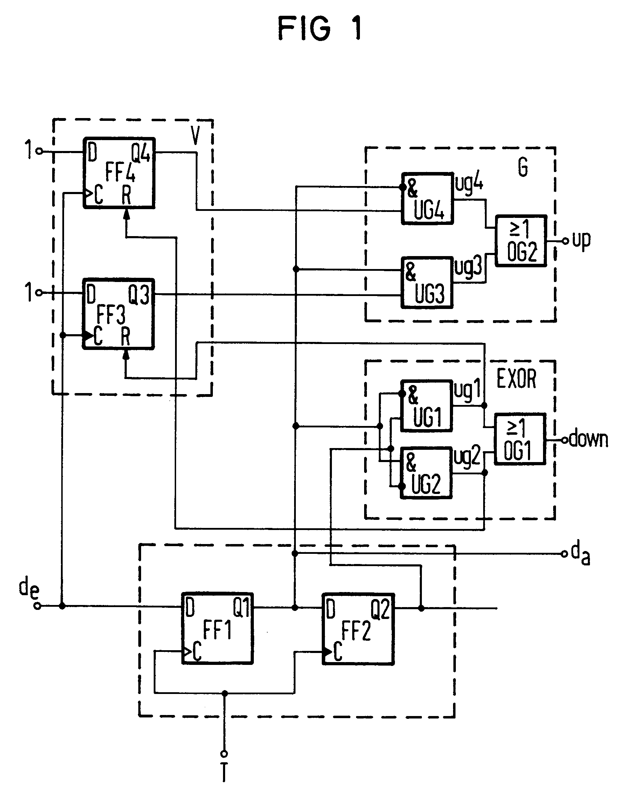

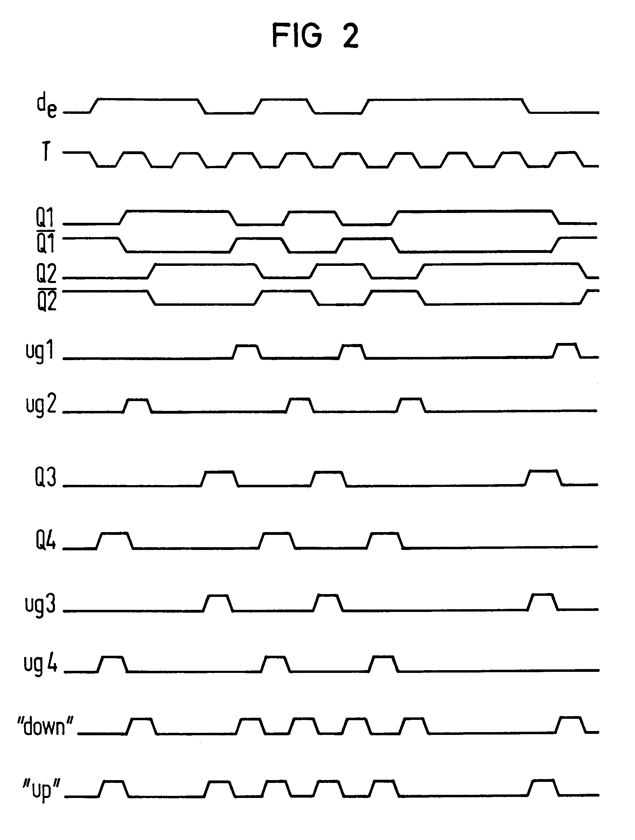

In der in FIG 1 schematisch dargestellten digitalen Phasendetektorschaltung mit einem ersten Phasenregelsignalausgang "down" und einem zweiten Phasenregelsignalausgang "up", bei der zwei in Kette geschaltete Kippglieder FF1, FF2 vorgesehen sind, wobei die Digitalsignalfolge gleichzeitig dem Signaleingang des Kippgliedes FF1 und einer Signalverzögerungseinrichtung V zugeführt wird, werden einerseits Ausgangssignale der Signalverzögerungseinrichtung V sowie Ausgangssignale des Kippgliedes FF1 über eine Verknüpfungsschaltung G zu dem Phasenregelausgangssignal "up" und andererseits Ausgangssignale der Kippstufen FF1 und FF2 über ein EXCLUSIV-ODER-Glied EXOR zu einem Phasenregelausgangssignal "down" zusammengefaßt.
Eine Digitalsignalfolge dₑ, wie sie in FIG 2 in Zeile dₑ angedeutet ist, und eine Referenztaktimpulsfolge T, wie sie in FIG 2 in Zeile T skizziert ist, mögen am Signaleingang D bzw. Takteingang C des Kippgliedes FF1 anliegen. Nach der bekannten Funktionsweise eines D-Kippgliedes wird die zugeführte Digitalsignalfolge am Signaleingang D mit der ansteigenden Taktflanke der Referenztaktimpulsfolge am Takteingang C übernommen und zum Ausgang Q1 des Kippgliedes durchgeschaltet. Das zweite Kippglied FF2 der in Kette geschalteten Kippglieder FF1, FF2 wird an seinem Signaleingang D durch die Ausgangssignalfolge des Kippgliedes FF1 und an seinem negierenden Takteingang C mit dem Referenztakt T beaufschlagt. An einem Schaltungsausgang dₐ kann mit der Ausgangssignalfolge des ersten Kippgliedes FF1 die eingangsseitig zugeführte Digitalsignalfolge dₑ (in FIG 2), nun aber im Referenztaktraster, wieder abgegriffen werden. Die zur Signalverzögerungseinrichtung V gehörenden Kippglieder FF3, FF4 werden gleichzeitig mit dem Kippglied FF1 mit der Digitalsignalfolge dₑ beaufschlagt. Die Digitalsignalfolge dₑ liegt am negierten Takteingang C des Kippgliedes FF3 und am Takteingang C des Kippgliedes FF4 an. Die Dateneingänge D der beiden Kippglieder FF3, FF4 sind fest mit einem "1"-Signal (logischer Pegel "1") beaufschlagt, so daß sich mit dem Auftreten ansteigender Digitalsignalflanken die in FIG 2 in den Zeilen Q3 und Q4 skizzierten Impulsfolgen an den Signalausgängen der Kippglieder FF3 und FF4 ergeben, wobei die Impulsdauer durch den Kippgliedern FF3, FF4 zugeführte Rücksetzsignale ug1 und ug2 bestimmt wird. Diese Rücksetzsignale ergeben sich aus UND-Verknüpfungen des Ausgangssignals Q̅1̅ bzw. Q1 des Kippgliedes FF1 mit dem Ausgangssignal Q̅2̅ bzw. Q2 des Kippgliedes FF2. Dafür sind zwei dem EXCLUSIV-ODER-Glied EXOR zugehörige UND-Glieder UG1, UG2 vorgesehen. In FIG 2 ist die am Ausgang des UND-Gliedes UG1 bzw. UG2 auftretende Impulsfolge mit ug1 bzw. ug2 bezeichnet.

Die am Datensignalausgang (Q1 in FIG 1) des ersten Kippgliedes FF1 auftretende Ausgangssignalfolge (Q1 in FIG 2) wird negiert mit der am Ausgang (Q4 in FIG 1) des Kippgliedes FF4 auftretenden Impulsfolge (Q4 in FIG 2) über das UND-Glied UG4 verknüpft; die am Ausgang des Kippgliedes FF3 auftretende Impulsfolge (Q3 in FIG 2) wird mit der Impulsfolge (Q1 in FIG 2) des Kippgliedes FF1 über ein UND-Glied UG3 verknüpft. Die daraus resultierenden Impulsfolgen ug3, ug4 (in FIG 2) über ein ODER-Glied OG2 zu einem "up-Signal" zusammengefaßt, wie es in FIG 2 in Zeile "up" angedeutet ist. Das für den Phasenvergleich nötige "down-Signal" wird in einer Verknüpfung der Impulsfolgen ug1 und ug2 durch das ODER-Glied OG1 des EXCLUSIV-ODER-Gliedes EXOR gebildet.

Die in der Zeichnung FIG 1 dargestellte Schaltungsanordnung zum digitalen Phasenvergleich von Digitalsignalen (z.B. Datensignalen) mit der Referenztaktimpulsfolge T liefert bei Phasengleichheit an den Ausgängen der ODER-Glieder OG1, OG2 gleiche Impulsfolgen "down", "up", die um eine halbe Taktperiode gegeneinander versetzt sind. Bei Phasenungleichheit zwischen Digitalsignal und Referenztaktimpulsfolge sind die Impulsfolgen "down", "up" in der Folge ihrer Impulse gleich, in der Dauer ihrer Impulse jedoch unterschiedlich, wie dies an sich (aus dem US-Patent 4 535 459 und IEEE ... (Siche vorne)) bekannt ist und daher hier nicht weiter erläutert zu werden braucht.

## Patentansprüche

1. Digitaler Phasendetektor mit zwei in Kette geschalteten bistabilen Kippgliedern (FF1, FF2),
wobei dem ersten Kippglied (FF1) an seinem Signaleingang (D) eine Digitalsignalfolge (dₑ) und an seinem Takteingang (C) eine Referenztaktimpulsfolge (T) zugeführt ist und der Ausgang (Q) des ersten Kippgliedes (FF1) mit dem Signaleingang (D) des zweiten Kippgliedes (FF2) verbunden ist, das an seinem Takteingang (C) gegensinnig zum ersten Kippglied (FF1) mit dem Referenztakt (T) beaufschlagt ist,
wobei ein mit seinem Ausgang einen ersten Phasenregelsignalausgang (down) bildendes EXCLUSIV-ODER-Glied (EXOR) eingangsseitig mit dem Signalausgang des ersten Kippgliedes (FF1) und mit dem Signalausgang des zweiten Kippgliedes (FF2) verbunden ist, und wobei eine mit ihrem Ausgang einen zweiten Phasenregelsignalausgang (up) bildende Verknüpfungsschaltung (G) eingangsseitig mit dem Signalausgang des ersten Kippgliedes (FF1) und mit einem Signalausgang einer Signalverzögerungseinrichtung (V) verbunden ist, die ihrerseits mit der Datensignalfolge (dₑ), beaufschlagt ist,
**dadurch gekennzeichnet,**
daß die Signalverzögerungseinrichtung (V) aus zwei dem ersten Kippglied (FF1) entsprechenden, gegensinnig zueinander mit der Datensignalfolge beaufschlagten bistabilen Kippgliedern (FF3, FF4) gebildet ist, welche jeweils beim Auftreten einer aufsteigenden Digitalsignalflanke am Ausgang (Q3) des einen Kippgliedes (FF3) der Signalverzögerungseinrichtung und beim Auftreten einer abfallenden Digitalsignalflanke am Ausgang (Q4) des anderen Kippgliedes (FF4) der Signalverzögerungseinrichtung ein Digitalsignal erzeugen, das jeweils durch ein Rücksetzsignal in seiner Signaldauer begrenzt wird und über die nachfolgende Verknüpfungsschaltung (G) das zugehörige Phasenregelsignal (up) erzeugt.

2. Digitaler Phasendetektor nach Anspruch 1,
**dadurch gekennzeichnet,**
daß der Signaleingang (D) jedes der gegensinnig zueinander mit der Datensignalfolge beaufschlagten Kippglieder (FF3, FF4) der Signalverzögerungseinrichtung mit einem Festsignal ("1") beaufschlagt ist und ein negierender Takteingang (C) des einen Kippgliedes (FF3) sowie ein nichtnegierender Takteingang (C) des anderen Kippgliedes (FF4) mit der Digitalsignalfolge (dₑ) beaufschlagt ist,
daß der Ausgang desjenigen UND-Gliedes (UG1) des mit zwei UND-Gliedern (UG1, UG2) und einem diese zusammenfassenden ODER-Glied gebildeten EXCLUSIV-ODER-Gliedes (EXOR), das mit dem negierten Ausgangssignal des ersten Kippgliedes (FF1) und mit dem nichtnegierten Ausgangssignal des zweiten Kippgliedes (FF2) gesteuert wird, mit einem Rücksetzeingang (R) des den negierenden Takteingang (C) aufweisenden Kippgliedes (FF3) der Signalverzögerungseinrichtung (V) verbunden ist,
und daß der Ausgang desjenigen UND-Gliedes (UG2) des EXCLUSIV-ODER-Gliedes (EXOR), das mit dem nichtnegierten Ausgangssignal des ersten Kippgliedes (FF1) und mit dem negierten Ausgangssignal des zweiten Kippgliedes (FF2) gesteuert wird, mit dem Rücksetzeingang (R) des den nichtnegierenden Takteingang (C) aufweisenden Kippgliedes (FF4) verbunden ist.

3. Digitaler Phasenregelkreis nach Anspruch 1 oder 2,
**dadurch gekennzeichnet,**
daß die der Signalverzögerungseinrichtung nachfolgende Verknüpfungsschaltung (G) aus zwei UND-Gliedern (UG3, UG4) und einem diese zusammenfassenden ODER-Glied (OG2) besteht, wobei der jeweils eine Eingang der beiden UND-Glieder (UG3, UG4) mit dem Signalausgang des einen bzw. anderen Kippgliedes (FF3 bzw. FF4) der Signalverzögerungseinrichtung (V) verbunden ist
und wobei der andere Eingang desjenigen UND-Gliedes (UG3), das mit dem mit der invertierten Datensignalfolge beaufschlagten einen Kippglied (FF3) der Verzögerungseinrichtung (V) verbunden ist, mit dem nichtinvertierten Ausgangssignal des ersten Kippgliedes (FF1) beaufschlagt wird,
während der andere Eingang des anderen UND-Gliedes (UG4) der Verknüpfungsschaltung (G) mit dem invertierten Ausgangssignal des ersten Kippgliedes (FF1) beaufschlagt wird.

4. Digitaler Phasendetektor nach einem der vorhergehenden Ansprüche,
**dadurch gekennzeichnet,**
daß das erste und zweite Kippglied (FF1, FF2) zusammen mit den Kippgliedern (FF3, FF4) der Signalverzögerungseinrichtung (V) in der gleichen Schichtebene eines integrierten Schaltkreises liegen.

## Claims

1. Digital phase detector having two flip-flops (FF1, FF2) connected in a chain network, the first flip-flop (FF1) being fed a digital signal sequence (dₑ) at its signal input (D) and being fed a reference clock pulse train (T) at its clock input (C), and the output (Q) of the first flip-flop (FF1) being connected to the signal input (D) of the second flip-flop (FF2), to the clock input (C) of which the reference clock pulse (T) is applied inversely relative to the first flip-flop (FF1) and an EXCLUSIVE-OR element (EXOR) which forms with its output a first phase control signal output (down) being connected on the input side to the signal output of the first flip-flop (FF1) and to the signal output of the second flip-flop (FF2), and a logic circuit (G) which forms with its output a second phase control signal output (up) being connected on the input side to the signal output of the first flip-flop (FF1) and to a signal output of a signal delay device (V), to which, for its part, the data signal seguence (dₑ) is applied, characterized in that the signal delay device (V) is formed from two flip-flops (FF3, FF4), which correspond to the first flip-flop (FF1), with the data signal sequence applied to them in a mutually inverse fashion, and in each case generate a digital signal upon the occurrence of a rising digital signal edge at the output (Q3) of one flip-flop (FF3) of the signal delay device and on the occurrence of a falling digital signal edge at the output (Q4) of the other flip-flop (FF4) of the signal delay device, said digital signal being limited in each case in its signal duration by a resetting signal and generating the associated phase control signal (up) via the following logic circuit (G).

2. Digital phase detector according to Claim 1, characterized in that a fixed signal ("1") is applied to the signal input (D) of each of the flip-flops (FF3, FF4) of the signal delay device to which the data signal sequence is applied in a mutually inverse fashion, and the digital signal sequence (dₑ) is applied to a negating clock input (C) of one flip-flop (FF3) and to a non-negating clock input (C) of the other flip-flop (FF4), in that the output of that AND element (UG1) of the EXCLUSIVE-OR element (EXOR) which is formed by two AND elements (UG1, UG2) and an OR element combining the latter and is controlled by the negated output signal of the first flip-flop (FF1) and by the non-negated output signal of the second flip-flop (FF2) is connected to a resetting input (R) of the flip-flop (FF3), having the negating clock input (C), of the signal delay device (V), and in that the output of that AND element (UG2) of the EXCLUSIVE-OR element (EXOR) which is controlled by the non-negated output signal of the first flip-flop (FF1) and by the negated output signal of the second flip-flop (FF2) is connected to the resetting input (R) of the flip-flop (FF4) having the non-negating clock input (C).

3. Digital phase detector according to Claim 1 or 2, characterized in that the logic circuit (G) following the signal delay device comprises two AND elements (UG3, UG4) and an OR element (OG2) combining the latter, one input of the two AND elements (UG3, UG4) being respectively connected to the signal output of the one or other flip-flop (FF3 and FF4, respectively) of the signal delay device (V), and the non-inverted output signal of the first flip-flop (FF1) being applied to the other input of that AND element (UG3) which is connected to the flip-flop (FF3) of the delay device (V) to which the inverted data signal sequence is applied, while the inverted output signal of the first flip-flop (FF1) is applied to the other input of the other AND element (UG4) of the logic circuit (G).

4. Digital phase detector according to one of the preceding claims, characterized in that the first and second flip-flops (FF1, FF2) are situated together with the flip-flops (FF3, FF4) of the signal delay device (V) in the same coating plane of an integrated circuit.

## Revendications

1. Détecteur de phase numérique comportant deux circuits à bascule bistable (FF1, FF2) branchés en série, et dans lequel
une suite de signaux numériques (dₑ) est envoyée à l'entrée de signaux (D) du premier circuit à bascule (FF1) et une suite d'impulsions de cadence de référence (T) est envoyée à l'entrée de cadence (C) de ce circuit, et la sortie (Q) du premier circuit à bascule (FF1) est raccordée à l'entrée des signaux (D) du second circuit à bascule (FF2), dont l'entrée de cadence (C) reçoit, en sens opposé par rapport au premier circuit à bascule (FF1), la cadence de référence (T),
et dans lequel un circuit OU-EXCLUSIF (EXOR), qui forme par sa sortie une première sortie du signal de régulation de phase (down) est relié côté entrée à l'entrée des signaux du premier circuit à bascule (FF1) et à la sortie des signaux du second circuit à bascule (FF2),
et dans lequel un circuit combinatoire (G), dont la sortie constitue une seconde sortie du signal de régulation de phase (up) est relié côté entrée à la sortie des signaux du premier circuit à bascule (FF1) et à une sortie des signaux d'un dispositif (V) de retardement des signaux, qui est chargé pour sa part par la suite de signaux de données (dₑ),
caractérisé par le fait
que le dispositif (V) de retardement des signaux est formé de deux circuits à bascule bistable (FF3, FF4), qui correspondent au premier circuit à bascule (FF1) et sont chargés en des sens réciproquement opposés par la suite de signaux de données et qui, respectivement lors de l'apparition d'un flanc montant du signal numérique au niveau de la sortie (Q3) d'un circuit à bascule (FF3) du dispositif de retardement de signaux et lors de l'apparition d'un flanc retombant du signal numérique au niveau de la sortie (Q4) de l'autre circuit à bascule (FF4) du dispositif de retardement des signaux, produisent un signal numérique, dont la durée est limitée respectivement par un signal de remise à l'état initial et qui produit, par l'intermédiaire du circuit combinatoire aval (G), le signal associé de régulation de phase (up).

2. Détecteur de phase numérique suivant la revendication 1, caractérisé par le fait que l'entrée des signaux (D) de chacun des circuits à bascule (FF3, FF4), qui sont chargés en des sens réciproquement opposés par la suite de signaux de données, du dispositif de retardement des signaux est chargée par un signal fixe ("1") et une entrée de cadence inverseuse (C) d'un circuit à bascule (FF3) ainsi qu'une entrée de cadence non inverseuse (C) de l'autre circuit à bascule (FF4) sont chargés par la suite de signaux numériques (dₑ),
que la sortie du circuit ET (UG1) du circuit OU-EXCLUSIF (EXOR) formée par deux circuits ET (UG1, UG2) et par un circuit OU réunissant ces deux circuits ET et qui est commandée par le signal de sortie inversé du premier circuit à bascule (FF1) et par le signal de sortie non négativé du second circuit à bascule (FF2), est connectée à une entrée de remise à l'état initial (R) du circuit à bascule (FF3), qui possède l'entrée de cadence inverseuse (C), du dispositif de retardement de signaux (V), et
que la sortie du circuit ET (UG2) du circuit OU-EXCLUSIF (EXOR), qui est commandée par le signal de sortie non inversé du premier circuit à bascule (FF1) et par le signal de sortie inversé du second circuit à bascule (FF2), est reliée à l'entrée de remise à l'état initial (R) du circuit à bascule (FF4), qui possède l'entrée de cadence non inverseuse (C).

3. Circuit de régulation de phase numérique suivant la revendication 1 ou 2, caractérisé par le fait que le circuit combinatoire (G), qui est branché en aval du dispositif de retardement des signaux, est constitué par le circuit ET (UG3, UG4) et par un circuit OU (OG2) réunissant ces deux circuits, respectivement une entrée des deux circuits ET (UG3, UG4) étant raccordée à la sortie de signaux de l'un ou de l'autre des circuits à bascule (FF3 ou FF4) du dispositif de retardement de signaux (V),
tandis que l'autre entrée du circuit ET (UG3), qui est reliée au premier circuit à bascule (FF3), qui est chargé par la suite inversée de signaux de données, du dispositif de retardement (V), est chargée par le signal de sortie non inversé du premier circuit à bascule (FF1),
alors que l'autre entrée de l'autre circuit ET (UG4) du circuit combinatoire (G) est chargée par le signal de sortie inversé du premier circuit à bascule (FF1).

4. Circuit de régulation de phase numérique suivant l'une des revendications précédentes, caractérisé par le fait que les premier et second circuits à bascule (FF1, FF2) sont situés, conjointement avec les circuits à bascule (FF3, FF4) du dispositif de retardement de signaux (V), dans le même plan de couche d'un circuit intégré.
